# EUROPEAN PATENT SPECIFICATION

(11) **EP 1 316 995 B1**
(45) Date of publication and mention of the grant of the patent: **17.12.2008**
(21) Application number: 01956884.9
(22) Date of filing: 14.08.2001
(51) Int. Cl.: H01L 21/768

(54) **SEMICONDUCTOR DEVICE AND METHOD FOR MANUFACTURING THE SAME**
HALBLEITERBAUELEMENT UND VERFAHREN ZU SEINER HERSTELLUNG
DISPOSITIF A SEMI-CONDUCTEURS ET SON PROCEDE DE FABRICATION

(30) Priority: 15.08.2000 JP 2000246494
(43) Date of publication of application: 04.06.2003
(73) Proprietor: TOKYO ELECTRON LIMITED, Minato-ku Tokyo 107-8481 (JP)
(72) Inventor: SENOO, Kouji c/o TOKYO ELECTRON AT LIMITED, Nirasaki-Shi, Yamanashi 407-0192 (JP); NAGAI, Hiroyuki c/o TOKYO ELECTRON LIMITED, Nirasaki-Shi, Yamanashi 407-0192 (JP)
(74) Representative: Liesegang, Eva
(86) International application number: PCT/JP2001/007017
(87) International publication number: WO 2002/015263

(56) References cited:
- EP-A- 0 834 916
- WO-A-00/42652
- WO-A-97/39484
- JP-A- 10 012 730
- JP-A- 11 040 666
- JP-A- 11 067 899
- JP-A- 2001 053 144
- US-A- 5 407 860
- US-A- 5 708 303
- US-A- 5 814 888

## Description

### BACKGROUND OF THE INVENTION

### 1. Field of the Invention

The present invention relates to semiconductor devices and methods of producing the same. More particularly, the present invention relates to a semiconductor device according to the preamble of claim 1. A device of this type is known from EP 0 834 916 A2.
Additionally, US-A-5,407,860 and US-A-5,814,888 show semiconductor devices including an insulating layer on which a number of interconnects are formed. These interconnects are covered by a second insulating layer in such a way that air gaps remain between the interconnects. The first mentioned document also describes to provide a non-wetting dielectric material on the side walls of hte interconnects and on the bottom of the space between the interconnects so as to discourage deposition of the insulating layer in the gaps between interconnects.

### 2. Description of the Related Art

Normally, a semiconductor device is formed by providing a plurality of interconnects and a plurality of electronic components on a substrate using a wafer.

In this case, when the interconnects are formed to project on the substrate by dry etching for instance, the surface of the substrate on which surface the interconnects are not formed is further covered, and at the same time, the spaces between the interconnects are filled with an interlayer insulating layer. Further, in this case, when the interlayer insulating layer is formed in multiple layers, the process of forming the interconnects and the process of forming the interlayer insulating layer are repeated a desired number of times. Alternately, the interconnects are also buried and formed in the substrate by a damascene process.

In the above-described semiconductor device, interconnect delay becomes an issue. The interconnect delay is proportional to the electric resistance of metal employed in the interconnects and the parasitic capacitance between the interconnect and the substrate or between the interconnects. With the recent progress of miniaturization, an increase in the electric resistance due to a decreased interconnect width and an increase in the parasitic capacitance due to a reduced interconnect pitch have become noticeable, thereby increasing the interconnect delay.
In order to reduce the interconnect delay, a material having a small dielectric constant is selected as the interlayer insulating layer, or it is considered to increase the interconnect pitch, at the stage of circuit designing, at a point where the interconnect delay becomes a problem.
On the other hand, there has been proposed a so-called air isolation method that reduces the dielectric constant between interconnects approximately to the level of air by omitting the interlayer insulating layer between interconnects, that is, by forming a gap between interconnects.
Of the above-described conventional methods, however, the former method of selecting a material of a small dielectric constant as the interlayer insulating layer can do no more than reduce the dielectric constant to at most two, and therefore, does not necessarily achieve the effect of reducing the interconnect delay sufficiently. Further, the progressing miniaturization leaves only a little room for the method of increasing the interconnect pitch to be employed. Particularly, the interconnect pitch may be unchangeable due to layout restrictions on the disposition of electronic components. Thus, this method does not necessarily achieve the effect of reducing the interconnect delay sufficiently, either.
On the other hand, the latter air isolation method, which still has a lot of problems including the securing of interconnect reliability, that is, the prevention of the deformation or breaking of the formed interconnects, has yet to be put to practical use.

### SUMMARY OF THE INVENTION

The present invention is made in view of the above-described problems, and has an object of providing a semiconductor device having reduced interconnect delay and increased reliability and a method of manufacturing the same. The present invention provides a semiconductor device according to claim 1 and a method of manufacturing a semiconductor device according to claim 3.

In order to achieve this object, a semiconductor device according to the present invention, which is formed by forming insulating layers on a substrate on which at least three or more interconnects are formed so as to project therefrom, is characterized in that an insulating film is buried selectively in a space between adjacent interconnects in which space interconnect delay is predicted to fall below a predetermined value due to interconnect design.

Here, interconnect delay is proportional to each of the electric resistance of an interconnect and the parasitic capacitance between interconnects. The former electric resistance and the latter capacitance are inversely proportional to the interconnect width and the interconnect pitch, respectively. Therefore, the magnitude of the interconnect delay can be predicted with respect to each interconnect. Accordingly, in the interconnect design, the space between interconnects where the interconnect delay exceeds a predetermined value and the space between interconnects where the interconnect delay falls below the predetermined value can be specified.

As previously described, the air isolation method, which forms a gap between interconnects, can reduce the interconnect delay. On the other hand, no insulating film is buried in the spaces between interconnects, so that the formed interconnects may be deformed or broken. Meanwhile, according to the present invention, an insulating film is buried selectively in the space between adjacent interconnects where the interconnect delay is predicted to fall below a predetermined value due to the interconnect design. Therefore, the interconnect delay is reduced, so that a semiconductor device having high interconnect reliability can be obtained.
Further, in this case, the semiconductor device is suitably formed by alternately forming the interconnects and the insulating layer so that two or more layers of the interconnects and two or more layers of the insulating layer are formed. The interconnects of the second layer are formed on the first insulating layer (interlayer insulating layer) so as to project therefrom, and the second insulating layer (interlayer insulating layer) is formed on the first insulating layer and the interconnects of the second layer.
Further, a method of manufacturing a semiconductor device according to the present invention, which method includes an interconnect forming step of forming at least three or more interconnects on a substrate so that the interconnects project therefrom and an interlayer insulating layer forming step of forming an interlayer insulating layer, is characterized by including an adhesion inhibiting layer forming step of forming an adhesion inhibiting layer inhibiting adhesion to the interlayer insulating layer between the interconnect forming step and the interlayer insulating layer forming step.
In the interconnect forming step, at least three or more interconnects may be suitably formed on the substrate so that the interconnects project therefrom by, for instance, a method forming an interconnect layer and thereafter performing dry etching using a predetermined mask. However, this is not the only method.
Further, in this case, the adhesion inhibiting layer is only formed in the space between adjacent interconnects in which space the interconnect delay is predicted to exceed the predetermined value. Thereby, it is ensured that the insulating film is buried in the space between adjacent interconnects of the larger interconnect pitch, so that a semiconductor device in which interconnect deformation and breaking is reduced can be obtained.
Further, in this case, the interconnect forming step and the interlayer insulating layer forming step may be repeated two or more times.

### BRIEF DESCRIPTION OF THE DRAWINGS

FIG. 1 is a block diagram of a manufacturing process for illustrating a method of manufacturing a semiconductor device according to an embodiment;
FIG. 2 is a fragmentary sectional view of a semiconductor device for illustrating the method of manufacturing a semiconductor device according to the first embodiment, showing a process of forming a base insulating layer;
FIG. 3 is a fragmentary sectional view of the semiconductor device for illustrating the method of manufacturing a semiconductor device according to the embodiment, showing a process of forming interconnects;
FIG. 4 is a fragmentary sectional view of the semiconductor device for illustrating the method of manufacturing a semiconductor device according to the embodiment, showing a process of forming an adhesion inhibiting layer;
FIG. 5 is a fragmentary sectional view of the semiconductor device for illustrating the method of manufacturing a semiconductor device according to the embodiment, showing a process of forming an interlayer insulating layer;
FIG. 6 is a fragmentary sectional view of the semiconductor device for illustrating the method of manufacturing a semiconductor device according to the embodiment, showing a process of forming additional interconnects;
FIG. 7 is a fragmentary sectional view of the semiconductor device for illustrating the method of manufacturing a semiconductor device according to the embodiment, showing a process of forming an additional adhesion inhibiting layer;
FIG. 8 is a fragmentary sectional view of the semiconductor device for illustrating the method of manufacturing a semiconductor device according to the embodiment, showing a process of forming an additional interlayer insulating layer;
FIG. 9 is a fragmentary sectional view of a semiconductor device according to an example not forming part of the present invention;
FIG. 10 is a fragmentary sectional view of a semiconductor device according to an example not forming part of the present invention; and
FIG. 11 is a fragmentary sectional view of a semiconductor device according to an example not forming part of the present invention.

### DETAILED DESCRIPTION OF THE PREFERRED EMBODIMENTS

A description will now be given, with reference to the drawings, of a preferred embodiment of a semiconductor device and a method of manufacturing the same according to the present invention.

### [Embodiment]

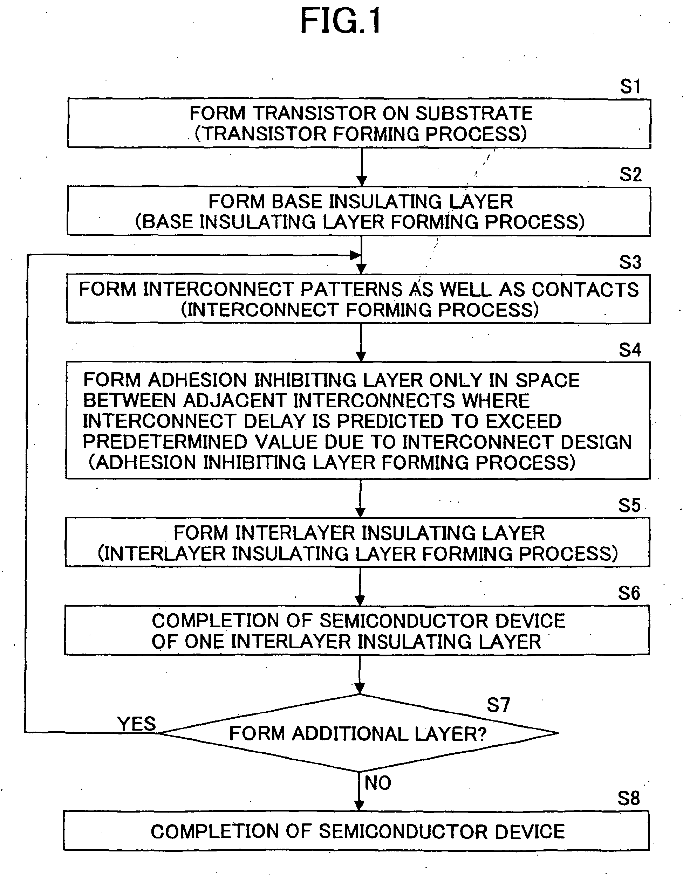

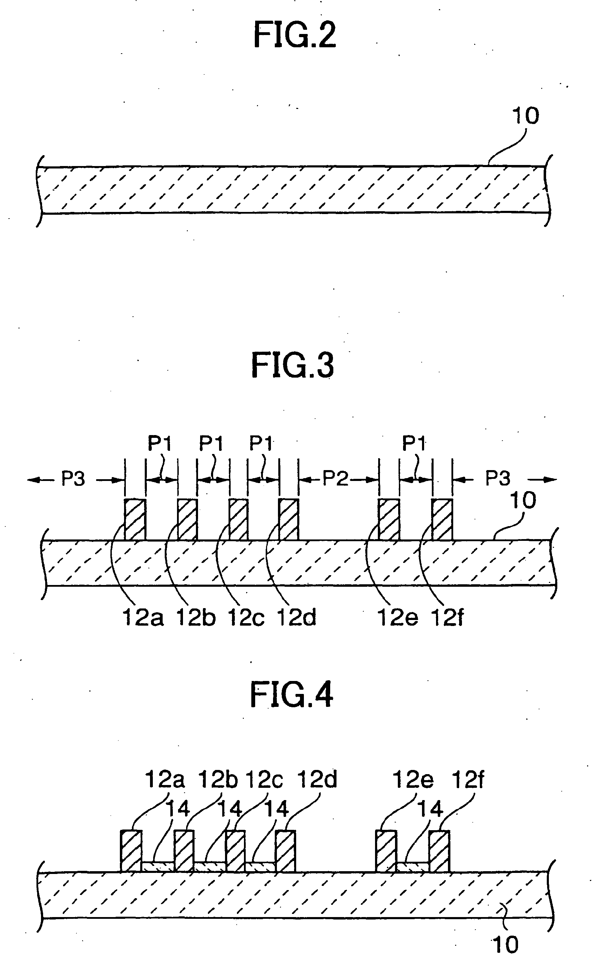

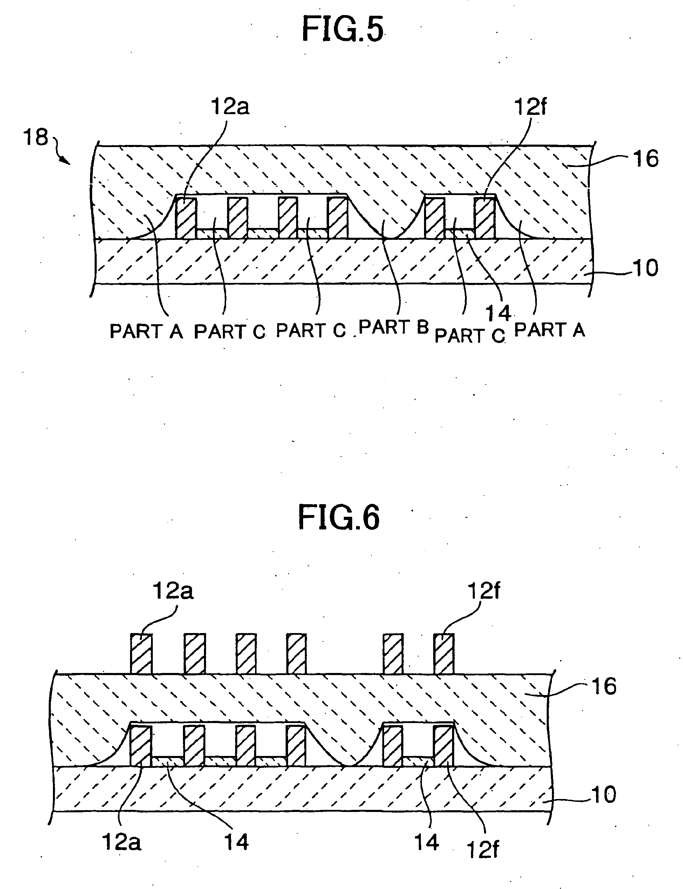

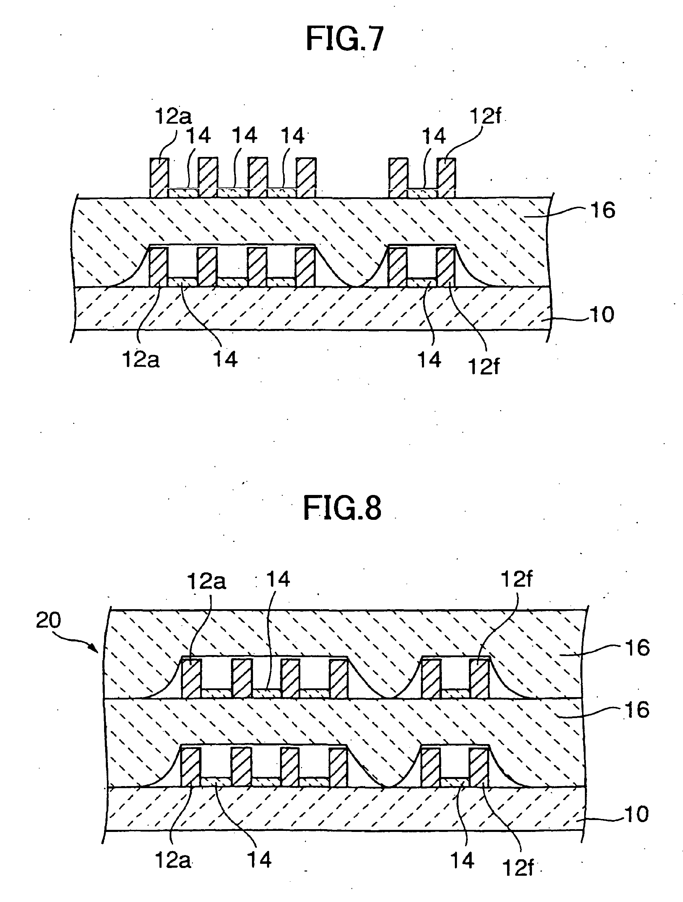

A description will be given of a semiconductor device and a method of manufacturing the same according to an embodiment with reference to the flowchart of FIG. 1 and the fragmentary sectional views of the semiconductor device of FIGS. 2 through 8.
First, for instance, a transistor (semiconductor device) is formed on a substrate formed of a wafer (a transistor forming process S1, the substrate and the transistor not shown in the drawings). Next, a base insulating layer 10 including SiO₂-based TEOS (tetraethylorthosilicate), for instance, is formed on it (a base insulating layer forming process S2, FIG. 2).
Next, an interconnect layer is formed on the base insulating layer 10. A plurality of interconnects (interconnect patterns) 12a through 12f are formed by dry etching with different interconnect pitches P1 through P3 (an interconnect forming process S3, FIG. 3). In this case, Al is employed as the interconnect material. At this point, together with the formation of the interconnects, necessary contact holes are formed in the base insulating layer 10, and contacts are further formed (not shown in the drawing).
Next, an adhesion inhibiting layer for inhibiting adhesion to a later-described interlayer insulating layer is formed only in the space between adjacent interconnects where the interconnect delay is predicted to exceed a predetermined value due to the interconnect design (an adhesion inhibiting layer forming process S4, FIG. 4).
Specifically, in this case, the interconnect delay is predicted to exceed the predetermined value in the spaces between the interconnects 12a and 12b, 12b and 12c, 12c and 12d, and 12e and 12f having the smaller interconnect pitches (P1 in FIG. 3). On the other hand, the interconnect delay is predicted to fall below the predetermined value in the spaces between the interconnects 12d and 12e, the interconnect 12a and its adjacent interconnect not shown in the drawing, and the interconnect 12f and its adjacent interconnect not shown in the drawing having the larger interconnect pitches (P2 and P3 in FIG. 3). Accordingly, for instance, with a mask, not shown in the drawing, being provided in the spaces between the interconnects 12d and 12e, the interconnect 12a and its adjacent interconnect not shown in the drawing, and the interconnect 12f and its adjacent interconnect not shown in the drawing having the larger interconnect pitches, the spaces between the interconnects 12a and 12b, 12b and 12c, 12c and 12d, and 12e and 12f having the smaller interconnect pitches are coated with an adhesion inhibiting agent, so that an adhesion inhibiting layer 14 is formed. In this case, instead of the method of providing the coating of the adhesion inhibiting agent, HMDS (hexamethyldisilazane) vapor, for instance, may be caused to circulate in the chamber as the adhesion inhibiting agent so that surface processing is performed.
Next, MSQ (methyl silsesquioxane), which is a hydrophilic inorganic material, for instance, is applied so that an interlayer insulating layer 16 is formed (an interlayer insulating layer forming process S5, FIG. 5). At this point, the interlayer insulating layer 16 adheres to the part of the base insulating layer 10 in which part the adhesion inhibiting layer 14 is not formed so that the insulating film is filled in the spaces between the adjacent interconnects (parts A and B in FIG. 5). The interlayer insulating layer 16, however, does not adhere to the part of the base insulating layer 10 in which part the adhesion inhibiting layer 14 is formed so that gaps are formed between the adjacent interconnects (parts C in FIG. 5). FIG. 5 provides a pictorial or schematic representation for convenience of description.
After the above-described interlayer insulating layer forming process (S5) is completed, baking and curing are further performed (not shown in the drawings). Thereby, a semiconductor device 18 having an interlayer insulating layer formed on a substrate on which interconnects are formed to project therefrom, or having an interconnect layer and an interlayer insulating layer formed therein, is completed (S6, FIG. 5).
In this case, successively thereafter, the above-described interconnect forming process, adhesion inhibiting layer forming process, and interlayer insulating layer forming process may be further repeated one or a plurality of times as required so that a semiconductor device having multiple interconnect layers and interlayer insulating layers formed therein is formed.
That is, successively after step 6 (S6), the interconnect forming process (FIG. 6), the adhesion inhibiting layer forming process (FIG. 7), and the interlayer insulating layer forming process (FIG. 8) that are steps 3 (S3) through 5 (S5), and processes including baking are performed (a multilayer forming process S7, FIGS. 6 through 8). Thereby, a semiconductor device 20 having multiple interconnect layers and interlayer insulating layers formed therein is completed (step 8, FIG. 8).
In the semiconductor devices 18 and 20 having the above-described configurations according to the first embodiment, a gap is formed between the adjacent interconnects having a small interconnect pitch. Therefore, the dielectric constant between the interconnects decreases so as to reduce the interconnect delay. Further, since an insulating film is buried selectively in a space between adjacent interconnects of a large interconnect pitch, the interconnect reliability can be secured.
In forming the plural interlayer insulating layers of the above-described semiconductor device 20, the adhesion inhibiting layer is provided for intervention for each of the interlayer insulating layers for the purpose of inhibiting adhesion.
The following examples do not form part of the invention.

### [First example]

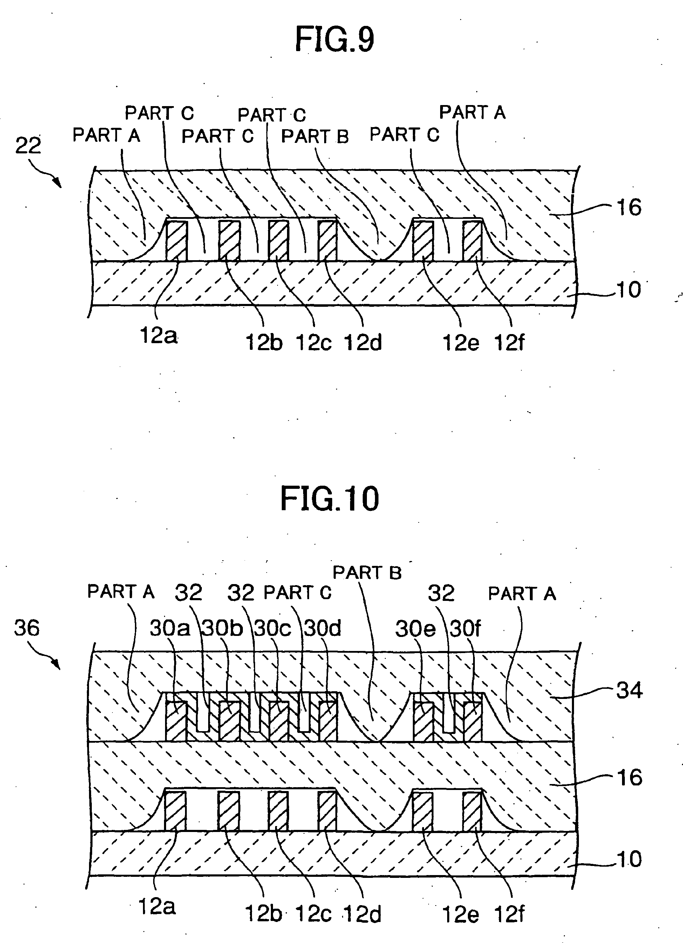

Next, a description will be given, with reference to FIG. 9, of a semiconductor device and a method of manufacturing the same.
In this example and the subsequent examples, the method of manufacturing a semiconductor device is basically the same. Therefore, the same elements as those of the first embodiment are referred to by the same numerals as those of the first embodiment, and a graphical representation of each manufacturing process will be omitted. Further, a description of the processes of manufacturing second and subsequent interlayer insulating layers will be omitted.
First, after forming a transistor on a substrate (a transistor forming process), the base insulating layer 10 including TEOS is formed on it (a base insulating layer forming process). Further, the interconnects 12a through 12f are formed using Al material on the base insulating layer 10 by dry etching with the different interconnect pitches P1 through P3 (see FIG. 3) (an interconnect forming process), and contacts are formed.
Next, SiLK (a registered trademark of The Dow Chemical Company), which is a hydrophobic organic material, for instance, is applied as insulating paste so that the interlayer insulating layer 16 is formed (an interlayer insulating layer forming process). At this point, after controlling the viscosity of SiLK to a predetermined value so as to prevent SiLK from entering the spaces between the adjacent interconnects 12a and 12b, 12b and 12c, 12c and 12d, and 12e and 12f having the smaller interconnect pitches (P1) in which spaces the interconnect delay is predicted to exceed a predetermined value due to the interconnect design (an insulating paste viscosity controlling process), SiLK is applied on the base insulating layer 10. The viscosity is controlled by changing the proportion of a solvent for SiLK.
Thereby, the interlayer insulating layer 16 is caused to adhere to the base insulating layer 10 in the parts (parts A and B in FIG. 9) having no interconnect formed therein between the interconnects 12d and 12e, the interconnect 12a and its adjacent interconnect not shown in the drawing, and the interconnect 12f and its adjacent interconnect not shown in the drawing provided with the larger interconnect pitches (P2 and P3). Meanwhile, the interlayer insulating layer 16 is prevented from adhering to the base insulating layer 10 in the parts (parts C in FIG. 9) between the interconnects 12a and 12b, 12b and 12c, 12c and 12d, and 12e and 12f where the viscosity is high so as to make it difficult for SiLK to enter. Accordingly, gaps are formed in the parts C.
Thereby, a semiconductor device 22 having an interconnect layer and an interlayer insulating layer formed therein is completed (FIG. 9).
In the semiconductor devices 22 according to the above-described example, a gap is formed between the adjacent interconnects having a small interconnect pitch. Therefore, the dielectric constant between the interconnects decreases so as to reduce the interconnect delay. Further, since an insulating film is buried selectively in a space between adjacent interconnects of a large interconnect pitch, the interconnect reliability can be secured.

### [Second Example]

Next, a description will be given, with reference to FIG. 10, of a semiconductor device and a method of manufacturing the same.
First, each layer is formed as in the semiconductor device 22 of the above-described first example. That is, after forming the interconnects 12a through 12f using Al on the base insulating layer 10 (an interconnect forming process), SiLK whose viscosity is controlled to a predetermined value is applied so that the interlayer insulating layer 16 is formed (an interlayer insulating layer forming process). Then, curing and other processes for stabilizing the interlayer insulating layer 16 are performed.
Next, the second interconnect and interlayer insulating layers are formed by a method somewhat different from that in the case of the first layers.
That is, before forming the second interlayer insulating layer after interconnects 30a through 30f of the second layer are provided to project from the first interlayer insulating layer 16, an oxide film 32 of hydrophilic SiO₂ is formed by, for instance, CVD selectively in the spaces between the interconnects 30a and 30b, 30b and 30c, 30c and 30d, and 30e and 30f having the smaller interconnect pitches (P1).
Next, like the first interlayer insulating layer 16, a second interlayer insulating layer 34 is formed by applying SiLK whose viscosity is controlled to the predetermined value (an interlayer insulating layer forming process). At this point, the hydrophilic oxide film 32 is formed in the spaces between the interconnects 30a and 30b, 30b and 30c, 30c and 30d, and 30e and 30f having the smaller interconnect pitches (P1). Therefore, in the parts C, the hydrophobic interlayer insulating layer 34 is prevented from adhering to the hydrophobic interlayer insulating layer 16 (parts C in FIG. 10), so that gaps are formed. On the other hand, the hydrophobic interlayer insulating layer 34 suitably adheres to the exposed hydrophobic interlayer insulating layer 16 in the spaces between the interconnects 30d and 30e, 30a and its adjacent interconnect not shown in the drawing, and 30f and its adjacent interconnect not shown in the drawing having the larger interconnect pitches (P2 and P3) (parts A and B in FIG. 10).
Thereby, a semiconductor device 36 having multiple interconnect layers and interlayer insulating layers formed therein is completed (FIG. 10).
In the semiconductor device 36 according to the above-described second example, a gap is formed between the adjacent interconnects having a small interconnect pitch. Therefore, the dielectric constant between the interconnects decreases so as to reduce the interconnect delay. Further, since an insulating film is buried selectively in a space between adjacent interconnects of a large interconnect pitch, the interconnect reliability can be secured.

### [Third Example]

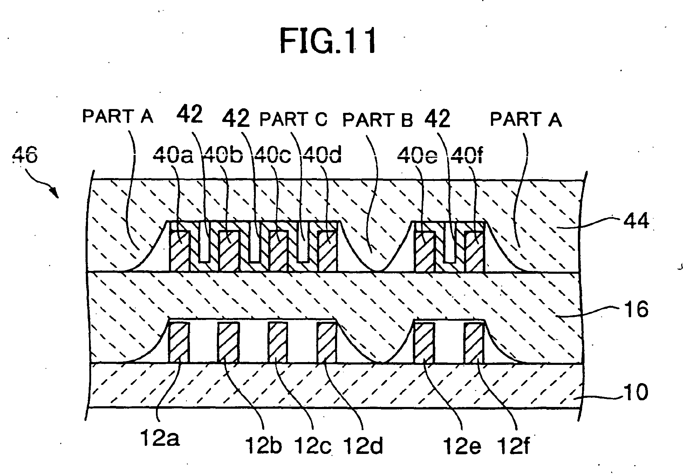

Next, a description will be given, with reference to FIG. 11, of a semiconductor device and a method of manufacturing the same.
First, each layer is formed as in the semiconductor device 22 of the above-described first example. That is, after the interconnects 12a through 12f are formed using Al on the base insulating layer 10 (an interconnect forming process), SiLK whose viscosity is controlled to a predetermined value is applied so that the interlayer insulating layer 16 is formed (an interlayer insulating layer forming process). Then, curing and other processes for stabilizing the interlayer insulating layer 16 are performed.
Next, the second interconnect and interlayer insulating layers are formed by a method different from that in the case of the first layers.
That is, before forming the second interlayer insulating layer after interconnects 40a through 40f of the second layer are formed to project from the first interlayer insulating layer 16, an organic thin film 42 of polymer material is formed by, for instance, CVD selectively in the spaces between the interconnects 40a and 40b, 40b and 40c, 40c and 40d, and 40e and 40f having the smaller interconnect pitches (P1, see FIG. 3). The degree of the hydrophobic property of the first hydrophobic interlayer insulating layer 16 can be further increased by forming the organic thin film 42 thereon. As is apparent from the following description, the organic thin film 42 serves as a layer inhibiting adhesion (an adhesion inhibiting layer forming process).
Next, as in the case of the above-described first embodiment, MSQ, which is inorganic material, is applied, so that a second interlayer insulating layer 44 is formed (an interlayer insulating layer forming process).
At this point, compared with in the spaces between the interconnects 40d and 40e, 40a and its adjacent interconnect not shown in the drawing, and 40f and its adjacent interconnect not shown in the drawing, hydrophobicity is increased in the spaces between the interconnects 40a and 40b, 40b and 40c, 40c and 40d, and 40e and 40f in which spaces the organic thin film 42 is formed. Therefore, the interlayer insulating layer 44 adheres to the interlayer insulating layer 16 in the former (parts A and B in FIG. 11), while in the latter, the interlayer insulating layer 44 is prevented from adhering to the interlayer insulating layer 16 (organic thin film 42) (parts C in FIG. 9) so that gaps are formed in the parts C. In this case, by controlling the viscosity of MSQ to a predetermined value, the effect of the viscosity control and the effect of the organic thin film 42 are combined with each other to be suitably produced.
Thereby, a semiconductor device 46 having a plurality of interconnect layers and interlayer insulating layers are formed therein is completed (FIG. 11). In this semiconductor device 46, the hydrophobic interlayer insulating film 16 and the hydrophilic interlayer insulating film 44 are alternately layered.

In the semiconductor device 46 according to the above-described third example, a gap is formed between the adjacent interconnects having a small interconnect pitch. Therefore, the dielectric constant between the interconnects decreases so as to reduce the interconnect delay. Further, since an insulating film is buried selectively in a space between adjacent interconnects of a large interconnect pitch, the interconnect reliability can be secured.

By balancing the adhesiveness of the surface and the surface tension, viscosity, and self-weight of the insulating paste, a space between adjacent interconnects of a smaller interconnect pitch is prevented from being filled with an insulating film, while a space between adjacent interconnects of a larger interconnect pitch is filled with an insulating film, so that the effects of the above examples can be produced with a reduced number of processes.

## Claims

1. A semiconductor device including a base insulating layer (10) and an insulating layer (16;) on the base insulating layer (10), wherein three or more interconnects (12a-12f) are formed on the base insulating layer (10) to project therefrom, wherein
the insulating layer (16;) is buried in a first space between first adjacent two of the interconnects (12a - 12f) having a first interconnect pitch (P2), and is not buried in a second space between second adjacent two of the interconnects (12a - 12f) having a second interconnect pitch (P1) smaller than the first interconnect pitch (P2) so as to form an air gap between the second adjacent two of the interconnects (12a - 12f), the first space having a predicted interconnect delay below a predetermined value and the second space having a predicted interconnect delay exceeding the predetermined value due to interconnect design, wherein
the insulating layer (16;) is in direct contact with the base insulating layer (10) in the first space; **characterized in that**
an adhesion inhibiting layer (14;) inhibiting adhesion between the base insulating layer and the insulating layer is formed only in the second space.

2. The semiconductor device as claimed in claim 1, **characterized in that** the interconnects (12a-f) and the insulating layer (16) are alternately formed so that two or more layers of the interconnects (12a-f) and two or more layers of the insulating layer (16) are formed with the adhesion inhibiting layer (14) provided for each of the layers of the interconnects (12a-f).

3. A method of manufacturing a semiconductor device, including the steps of (a) forming a first insulating layer (10), (b) forming three or more interconnects (12a - 12f) on the first insulating layer (10) so that the interconnects project from the first insulating layer, and (c) forming a second insulating layer (16;) on the first insulating layer (10) after said step (b), **characterized in that**
said step (c) buries the second insulating layer (16;) in a first space between first adjacent two of the interconnects (12a - 12f) having a first interconnect pitch (P2) so that the insulating layer (16;) is in direct contact with the first insulating layer (10) in the first space, and does not bury the second insulating layer (16;) in a second space between second adjacent two of the interconnects (12a - 12f) having a second interconnect pitch (P1) smaller than the first interconnect pitch (P2) so as to form an air gap between the second adjacent two of the interconnects (12a - 12f), the first space having a predicted interconnect delay below a predetermined value and the second space having a predicted interconnect delay exceeding the predetermined value due to interconnect design,
wherein the method is further **characterized by** the step of (d) forming an adhesion inhibiting layer (14;) inhibiting adhesion between the first and second insulating layers (10; 16; 34; 44) so that the adhesion inhibiting layer is formed only in the second space, said step (d) being performed between said steps (b) and (c).

4. The method as claimed in claim 3, **characterized in that** said steps (b) and (c) are repeated two or more times so that two or more layers of the interconnects (12a-f) and two or more layers of the insulating layer (16) are formed with the adhesion inhibiting layer (14) provided for each of the layers of the interconnects (12a-f).

## Patentansprüche

1. Halbleiter-Bauteil mit einer Basis-Isolierungsschicht (10) und einer Isolierungsschicht (16) auf der Basis-Isolierungsschicht (10), wobei drei oder mehr Verbindungselemente (12a-12f) auf der Basis-Isolierungsschicht (10) so ausgebildet sind, dass sie von dieser hervorstehen, wobei
die Isolierungsschicht (16) in einem ersten Raum zwischen einem ersten Paar von benachbarten Verbindungselementen (12a-12f) eingelassen ist, die einen ersten Verbindungselement-Abstand (P2) aufweisen, und nicht in einem zweiten Raum zwischen einem zweiten Paar von Verbindungselementen (12a-12f) eingelassen ist, welches einen zweiten Verbindungselement-Abstand (P1) aufweist, welcher geringer als der erste Verbindungselement-Abstand (P2) ist, um einen mit Luft gefüllten Zwischenraum zwischen dem zweiten Paar von benachbarten Verbindungselementen (12a-12f) auszubilden, wobei aufgrund des Designs der Verbindungselemente der erste Raum eine vorhergesagte Verbindungselement-Verzögerung aufweist, die niedriger als ein vorbestimmter Wert ist, und der zweite Raum eine vorhergesagte Verbindungselement-Verzögerung aufweist, die den vorbestimmten Wert übersteigt,
wobei die Isolierungsschicht (16) sich in direktem Kontakt mit der Basis-Isolierungsschicht (10) in dem ersten Raum befindet, **dadurch gekennzeichnet, dass** eine Anhaftungs-Vermeidungsschicht (14), die eine Anhaftung zwischen der Basis Isolierungsschicht und der Isolierungsschicht vermeidet, nur in dem zweiten Raum ausgebildet ist.

2. Halbleiterbauteil nach Anspruch 1, **dadurch gekennzeichnet, dass** die Verbindungselemente (12a-12f) und die Isolierungsschicht (16) abwechselnd so ausgebildet sind, dass zwei oder mehr Schichten der Verbindungselemente (12a-12f) und zwei oder mehr Schichten der Isolierungsschicht (16) ausgebildet sind, wobei die Anhaftungs-Vermeidungsschicht (14) für eine jede der Schichten von Verbindungselementen (12a-12f) vorgesehen ist.

3. Verfahren zum Herstellen eines Halbleiterbauteils, mit den folgenden Schritten:
(a) Ausbilden einer ersten Isolierungsschicht (10),
(b) Ausbilden von drei oder mehr Verbindungselementen (12a-12f) auf der Isolierungsschicht (10), so dass die Verbindungselemente von der ersten Isolierungsschicht vorstehen, und
(c) Ausbilden einer zweiten Isolierungsschicht (16) auf der ersten Isolierungsschicht (10) nach Schritt (b), **dadurch gekennzeichnet, dass**
in dem Schritt (c) die zweite Isolierungsschicht in einem Zwischenraum zwischen einem ersten Paar aus zwei benachbarten Verbindungselementen (12a-12f), welche einen ersten Verbindungselement-Abstand (P2) haben, eingelassen wird, so dass die Isolierungsschicht (16) sich in direktem Kontakt mit der ersten Isolierungsschicht (10) in dem ersten Raum befindet, und die zweite Isolierungsschicht (16) nicht in einem zweiten Raum zwischen einem zweiten Paar von zwei benachbarten Verbindungselementen (12a-12f) eingelassen wird, die einen zweiten Verbindungselement-Abstand (P1) aufweisen, welcher geringer als der erste Verbindungselement-Abstand (P2) ist, um einen mit Luft gefüllten Zwischenraum zwischen dem zweiten Paar von benachbarten Verbindungselementen (12a-12f) auszubilden, wobei aufgrund des Designs der Verbindungselemente der erste Raum eine vorhergesagte Verbindungselement-Verzögerung aufweist, die niedriger als ein vorbestimmter Wert ist, und der zweite Raum eine vorhergesagte Verbindungselement-Verzögerung aufweist, die den vorbestimmten Wert übersteigt,
wobei das Verfahren ferner durch einen Schritt (d) gekennzeichnet ist, in dem eine Anhaftungs-Vermeidungsschicht (14), welche eine Anhaftung zwischen der ersten und der zweiten Isolierungsschicht (10, 16, 34, 44) vermeidet, so ausgebildet wird, dass die Anhaftungs-Vermeidungsschicht nur in dem zweiten Raum ausgebildet wird, wobei der Schritt (d) zwischen den Schritten (b) und (c) ausgeführt wird.

4. Verfahren nach Anspruch 3, bei dem die Schritte (b) und (c) mindestens zweimal wiederholt werden, so das zwei oder mehr Schichten von Verbindungselementen (12a-12f) und zwei oder mehr Schichten der Isolierungsschicht (16) ausgebildet werden, wobei die Anhaftungs-Vermeidungsschicht (14) für eine jede dieser Schichten von Verbindungselementen (12a-12f) vorgesehen wird.

## Revendications

1. Dispositif à semi-conducteur comprenant une couche isolante de base (10) et une couche isolante (16) sur la couche isolante de base (10), dans lequel trois interconnexions ou plus (12a - 12f) sont formées sur la couche isolante de base (10) de sorte à se projeter à partir de celle-ci, dans lequel la couche isolante (16) est enfouie dans un premier espace entre les deux premières interconnexions adjacentes des interconnexions (12a - 12f) ayant un premier pas d'interconnexion (P2), et n'est pas enfouie dans un second espace entre les deux secondes interconnexions adjacentes des interconnexions (12a - 12f) ayant un second pas d'interconnexion (P1) plus petit que le premier pas d'interconnexion (P2) de sorte à former une lame d'air entre les deux secondes interconnexions adjacentes (12a - 12f), le premier espace ayant un retard d'interconnexion prédit en deçà d'une valeur prédéterminée et le second espace ayant un retard d'interconnexion prédit dépassant la valeur prédéterminée du fait de la conception des interconnexions, dans lequel
la couche isolante (16) est en contact direct avec la couche isolante de base (10) dans le premier espace, **caractérisé en ce que**
une couche inhibitrice d'adhésion (14) empêchant l'adhésion entre la couche isolante de base et la couche isolante est formée uniquement dans le second espace.

2. Dispositif à semi-conducteur selon la revendication 1, **caractérisé en ce que** les interconnexions (12a-f) et la couche isolante (16) sont formées en alternance de sorte que deux ou plusieurs couches des interconnexions (12a-f) et deux ou plusieurs couches de la couche isolante (16) sont formées avec la couche inhibitrice d'adhésion (14) prévue pour chacune des couches des interconnexions (12a-f).

3. Procédé de fabrication d'un dispositif à semi-conducteur, comprenant les étapes consistant à
(a) former une première couche isolante (10),
(b) former trois interconnexions ou plus (12a - 12f) sur la première couche isolante (10) de sorte que les interconnexions fassent saillie de la première couche isolante, et (c) former une seconde couche isolante (16) sur la première couche isolante (10) après ladite étape (b), **caractérisé en ce que**
ladite étape (c) consiste à enfouir la seconde couche isolante (16) dans un premier espace entre les deux premières interconnexions adjacentes des interconnexions (12a - 12f) ayant un premier pas d'interconnexion (P2), de sorte que la couche isolante (16) soit en contact direct avec la première couche isolante (10) dans le premier espace, et à ne pas enfouir la seconde couche isolante (16) dans un second espace entre les deux secondes interconnexions adjacentes des interconnexions (12a - 12f) ayant un second pas d'interconnexion (P1) plus petit que le premier pas d'interconnexion (P2) de sorte à former une lame d'air entre les deux secondes interconnexions adjacentes des interconnexions (12a - 12f), le premier espace ayant un retard d'interconnexion prédit en deçà d'une valeur prédéterminée et le second espace ayant un retard d'interconnexion prédit dépassant la valeur prédéterminée du fait de la conception des interconnexions ;
dans lequel le procédé est en outre **caractérisé par** l'étape consistant à (d) former une couche inhibitrice d'adhésion (14) empêchant l'adhésion entre les première et seconde couches isolantes (10 ; 16 ; 34 ; 44) de sorte que la couche inhibitrice d'adhésion est formée uniquement dans le second espace, ladite étape (d) étant effectuée entre lesdites étapes (b) et (c).

4. Procédé selon la revendication 3, **caractérisé en ce que** lesdites étapes (b) et (c) sont répétées deux fois ou plus de sorte que deux couches ou plus des interconnexions (12a-f) et deux couches ou plus de la couche isolante (16) sont formées avec la couche inhibitrice d'adhésion (14) prévue pour chacune des couches des interconnexions (12a-f).
